# DEMANDE DE BREVET EUROPEEN

(11) **EP 3 790 014 A1**
(43) Date de publication de la demande: **10.03.2021**
(21) Numéro de dépôt: 20192979.1
(22) Date de dépôt: 26.08.2020
(51) Int. Cl.: G11C 29/02, G11C 29/26, G11C 29/38, G11C 29/40, G11C 29/42, G11C 29/52, G06F 11/10, G06F 11/16, G06F 12/02

(54) **DÉTECTION D'ERREURS**

(30) Priorité: 04.09.2019 FR 1909725
(71) Demandeur: STMicroelectronics (Rousset) SAS, 13790 Rousset (FR)
(72) Inventeur: ROMAIN, Fabrice, 83560 RIANS (FR); LISART, Mathieu, 13100 AIX EN PROVENCE (FR)
(74) Mandataire: Cabinet Beaumont

(57) **Abrégé**

La présente description concerne un procédé de détection d'une erreur d'écriture d'une donnée (Data5) en mémoire dans lequel :
- au moins deux parties (Code5A, Code5B) de même taille d'un mot binaire (Code5) représentatif de ladite donnée (Data5) sont stockées à la même adresse (AddL5) dans au moins deux circuits mémoire (51, 52) identiques ; et
- des signaux internes de commande des deux circuits mémoire (51, 52) sont comparés.

## Description

### Domaine technique

La présente description concerne, de façon générale, les systèmes et circuits électroniques, et, plus particulièrement, les systèmes et circuits électroniques comprenant des mémoires. La présente description concerne, de façon encore plus particulière, la lecture et l'écriture de données dans ces mémoires, et, plus précisément, la détection d'erreurs lors de lectures ou d'écritures de données.

### Technique antérieure

La gestion de données, pendant le fonctionnement d'un système, ou d'un circuit électronique, nécessite généralement l'utilisation d'une ou plusieurs mémoires. Des données de fonctionnement sont, par exemple, écrites et/ou lues à partir de ces mémoires avant, ou après, avoir été utilisées.

De nombreuses erreurs, ou fautes, peuvent être rencontrées pendant la lecture et/ou l'écriture d'une donnée dans une mémoire. A titre d'exemple, une erreur de lecture peut consister en la lecture d'une donnée à une adresse erronée. Une erreur d'écriture peut consister en l'écriture d'une donnée à une adresse erronée. Ces erreurs peuvent être accidentelles ou volontaires. A titre d'exemple, une erreur volontaire peut être produite par un procédé d'injection de fautes, par exemple mis en oeuvre par un attaquant, dans le but de modifier le fonctionnement du système électronique.

Il serait souhaitable de pouvoir améliorer, au moins en partie, certains aspects des procédés de lecture et/ou d'écriture de données en mémoire, et plus particulièrement, certains aspects des procédés de détection d'erreurs de lecture et/ou d'écriture de données en mémoire.

### Résumé de l'invention

Il existe un besoin pour des procédés de lecture et/ou d'écriture de données dans des mémoires plus fiables.

Il existe un besoin pour des procédés de détection d'erreurs de lecture et/ou d'écriture plus performants.

Il existe un besoin pour des procédés de détection d'erreurs de lecture et/ou d'écriture adaptés à détecter des erreurs dans lesquelles des données sont écrites à une adresse erronée.

Un mode de réalisation pallie tout ou partie des inconvénients des procédés d'écriture de données en mémoire connus.

Un mode de réalisation pallie tout ou partie des inconvénients des procédés de lecture de données en mémoire connus.

Un mode de réalisation pallie tout ou partie des inconvénients des procédés de détection d'erreurs de lecture et/ou d'écriture en mémoire connus.

Un mode de réalisation prévoit un procédé de détection d'une erreur d'écriture d'une donnée en mémoire dans lequel : au moins deux parties de même taille d'un mot binaire représentatif de ladite donnée sont stockées à la même adresse dans au moins deux circuits mémoire identiques ; et des signaux internes de commande des deux circuits mémoire sont comparés.

Selon un mode de réalisation, les signaux internes comprennent un signal de mots.

Selon un mode de réalisation, les signaux internes comprennent un signal de sélection d'un des circuits mémoire.

Selon un mode de réalisation, les signaux internes comprennent un signal d'activation d'écriture.

Selon un mode de réalisation, les signaux internes comprennent un signal de sélection/numéro de colonne.

Selon un mode de réalisation, les signaux internes comprennent un signal de sélection/numéro de ligne.

Selon un mode de réalisation, le mot binaire est obtenu à partir de ladite donnée et d'un code correcteur ou détecteur d'erreur, ledit code correcteur ou détecteur d'erreur étant représentatif de ladite donnée et de ladite adresse.

Selon un mode de réalisation, le mot binaire est obtenu par concaténation de ladite donnée et du code correcteur ou détecteur d'erreur.

Selon un mode de réalisation, le code correcteur ou détecteur d'erreur est représentatif de ladite donnée et de ladite adresse.

Selon un mode de réalisation, le code correcteur ou détecteur d'erreur est obtenu par un procédé de signature.

Un autre mode de réalisation prévoit un procédé d'écriture en mémoire d'une donnée, dans lequel : un mot binaire, représentatif de ladite donnée et d'un code correcteur ou détecteur d'erreur, est scindé en au moins une première et une deuxième parties ; et ladite première partie est écrite à une adresse logique dans un premier circuit mémoire ; et ladite deuxième partie est écrite à ladite adresse logique dans un deuxième circuit mémoire adapté à stocker autant de mots binaires que ledit premier circuit mémoire, ledit code correcteur ou détecteur d'erreur étant dépendant de ladite donnée et de ladite adresse.

Selon un mode de réalisation, lesdites première et deuxième partie sont de même taille.

Selon un mode de réalisation, le mot binaire est une concaténation de ladite donnée et dudit code correcteur ou détecteur d'erreur.

Selon un mode de réalisation, ladite donnée et ladite adresse sont fournies par un unique premier processeur.

Selon un mode de réalisation, ladite donnée et ladite adresse sont fournies par au moins un deuxième processeur et un troisième processeur.

Selon un mode de réalisation, ladite donnée fournie par le deuxième processeur est comparée à ladite donnée fournie par le troisième processeur, et ladite adresse fournie par le deuxième processeur est comparée à ladite adresse fournie par le troisième processeur.

Selon un mode de réalisation, le deuxième processeur fournit ladite adresse à un desdits au moins deux circuits mémoire, et le troisième processeur fournit ladite adresse à un autre desdits au moins deux circuits mémoire.

Selon un mode de réalisation, le deuxième processeur fournit ladite adresse auxdits au moins deux circuits mémoire.

Selon un mode de réalisation, lesdits premier et deuxième circuits mémoire sont de même taille.

Selon un mode de réalisation, des signaux internes de commande desdits au moins deux circuits mémoire sont comparés.

Un autre mode de réalisation prévoit un procédé de lecture d'une donnée écrite selon le procédé décrit ci-dessus.

Selon un mode de réalisation, ledit mot binaire est formé en concaténant lesdites première et deuxième parties lues dans lesdits premier et deuxième circuits mémoire .

Selon un mode de réalisation, la donnée est obtenue en retirant le code correcteur ou détecteur d'erreur du mot binaire.

Un autre mode de réalisation prévoit un procédé de détection d'une erreur dans une donnée écrite par le procédé décrit ci-dessus, dans lequel le code correcteur ou détecteur d'erreur est calculé de nouveau à partir de la donnée lue par le procédé le procédé décrit ci-dessus.

Selon un mode de réalisation, le code correcteur ou détecteur d'erreur est vérifié.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, schématiquement et sous forme de blocs, une partie d'une architecture d'un mode de réalisation d'un système électronique ;
la figure 2 représente, schématiquement et sous forme de blocs, une autre partie de l'architecture du système de la figure 1 ;
la figure 3 représente, schématiquement et sous forme de blocs, une partie d'une architecture d'un autre mode de réalisation d'un système électronique ;
la figure 4 représente, schématiquement et sous forme de blocs, une autre partie de l'architecture du système de la figure 3 ;
la figure 5 représente, schématiquement et sous forme de blocs, une partie d'une architecture d'un autre mode de réalisation d'un système électronique ;
la figure 6 représente, schématiquement et sous forme de blocs, une autre partie de l'architecture du système de la figure 5 ;
la figure 7 représente, schématiquement et sous forme de blocs, une partie d'une architecture d'un autre mode de réalisation d'un système électronique ;
la figure 8 représente, schématiquement et sous forme de blocs, une autre partie de l'architecture du système de la figure 7 ;
la figure 9 représente, schématiquement et sous forme de blocs, une partie d'une architecture d'un circuit mémoire ; et
la figure 10 représente, schématiquement et sous forme de blocs, une partie de l'architecture d'un autre mode de réalisation d'un système électronique.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Dans la suite de la description, on appelle scission, découpage, ou division d'un mot binaire initial en plusieurs parties, la formation de plusieurs mots binaires secondaires à partir de bits du mot binaire initial. Plus précisément, chaque mot binaire secondaire est composé de telle façon que la concaténation de tous les mots binaires secondaires, dans un ordre précis, donne le mot binaire initial.

De plus, dans la suite de la description, on appelle adresse logique une adresse générée par un processeur et destinée à un circuit mémoire. Cette adresse est décodée par un circuit décodeur d'adresses associé au circuit mémoire et qui fournit une adresse physique en termes de coordonnées (ligne-colonne) dans le plan mémoire.

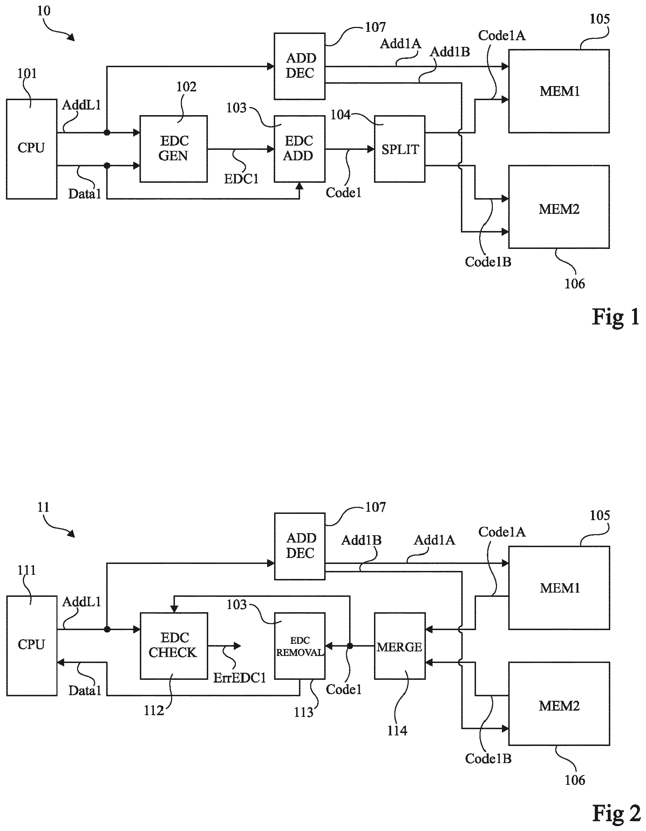

La figure 1 représente, schématiquement et sous forme de blocs, une partie 10 d'une architecture d'un mode de réalisation d'un système électronique 1. La partie 10 est adaptée à l'écriture de données en mémoire du système électronique 1.

La partie 10 comprend :
- un processeur 101 (CPU) ;
- un circuit 102 (EDC GEN) de génération d'un code correcteur ou détecteur d'erreur ;
- un circuit 103 (EDC ADD) de formation d'un mot binaire ;
- un circuit 104 (SPLIT) de division d'un mot binaire ;
- deux circuits mémoire 105 (MEM1) et 106 (MEM2) ; et
- un circuit décodeur d'adresses 107 (ADD DEC).

Le processeur 101 est un processeur adapté à demander l'écriture de données dans les mémoires 105 et 106. Le processeur 101 fournit, en sortie, une donnée Data1 à écrire et une adresse logique AddL1. L'adresse AddL1 est l'adresse logique à laquelle la donnée Data1 doit être écrite en mémoire. A titre d'exemple, l'adresse logique AddL1 est un mot binaire dont les bits de poids fort indiquent la ligne du circuit mémoire à laquelle doit être écrit le mot binaire, et les bits de poids faibles indiquent la colonne du circuit mémoire à laquelle doit être écrit le mot binaire.

Le circuit 102 de génération d'un code correcteur ou détecteur d'erreur est un circuit adapté à calculer un code EDC1 détecteur d'erreur (EDC, error detecting code), ou un code correcteur d'erreur (ECC, error correcting code), représentatif de la donnée Data1 et de l'adresse logique AddL1. Ainsi, le circuit 102 reçoit, en entrée, la donnée Data1 et l'adresse logique AddL1, et fournit, en sortie, le code correcteur ou détecteur d'erreur EDC1. A titre d'exemple, le code EDC1 est obtenu en utilisant un algorithme de signature.

Le circuit 103 de formation d'un mot binaire est un circuit adapté à former un mot binaire Code1 représentatif de la donnée Data1 et du code EDC1. Le circuit 103 reçoit, en entrée, la donnée Data1 et le code EDC1, et fournit, en sortie, le mot binaire Code1. A titre d'exemple, la donnée Data1 et le code EDC1 sont concaténés par le circuit 103 pour former le mot binaire Code1. L'ordre dans lequel la donnée Data1 et le code EDC1 sont concaténés pour former le mot binaire Code1 n'a pas d'importance.

Le circuit 104 de division de mots binaires est un circuit adapté à scinder le mot binaire Code1 en plusieurs mots binaires. Le circuit 104 reçoit, en entrée, le mot binaire Code1, et fournit, en sortie, dans cet exemple, deux mots binaires Code1A et Code1B. Autrement dit, la concaténation des mots binaires Code1A et Code1B, dans un ordre précis, donne le mot binaire Code1. Les mots binaires Code1A et Code1B sont, par exemple, de taille différente. A titre de variante, les mots binaires Code1A et Code1B sont de même taille, c'est-à-dire qu'ils comprennent chacun la moitié des bits du mot binaire Code1.

Le circuit 107 décodeur d'adresses est un circuit adapté à fournir des adresses physiques lisibles par des circuits mémoire à partir d'une adresse logique. Le circuit 107 reçoit, en entrée, l'adresse logique AddL1, et fournit, en sortie, deux adresses physiques Add1A et Add1B. Le circuit 107 permet, plus particulièrement, de définir, à partir de l'adresse logique AddL1 fournie par le processeur 101, les deux adresses physiques Add1A et Add1B auxquelles les mots binaires Code1A et Code1B vont être écrits dans les circuits mémoire 105 et 106. A titre d'exemple, les adresses Add1A et Add1B sont identiques.

Les circuits mémoire 105 et 106 sont adaptés à stocker les mots binaires Code1A et Code1B respectivement aux adresses Add1A et Add1B. Ainsi, la mémoire 105 reçoit, en entrée, le mot binaire Code1A et l'adresse Add1A, et la mémoire 106 reçoit, en entrée, le mot binaire Code1B et l'adresse Add1B. Les circuits mémoire 105 et 106 sont adaptés à stocker le même nombre de mots binaires. Les circuits mémoire 105 et 106 sont, par exemple, des mémoires volatiles. A titre d'exemple, les circuits mémoire 105 et 106 sont de même taille.

A titre de variante, la partie 10 pourrait comprendre plus de deux circuits mémoire identiques en structure et en taille. Dans ce cas, le circuit 104 serait adapté à fournir autant de mots binaires que de circuits mémoire compris dans la partie 10. Autrement dit, le circuit 104 est adapté à diviser le mot binaire Code1 en autant de parties que de circuits mémoire compris dans la partie 10. De plus, le circuit 107 est adapté à fournir autant d'adresses physiques à partir de l'adresse logique AddL1 que de circuits mémoire compris dans la partie 10.

Un procédé d'écriture en mémoire de la donnée Data1 mettant en oeuvre la partie 10 du système 1 est le suivant. Quand le processeur 101 veut stocker la donnée Data1 en mémoire, il génère l'adresse AddL1 à laquelle il souhaite la stocker. Le processeur 101 fournit alors la donnée Data1 et l'adresse logique AddL1 au circuit 102 pour que celui-ci génère le code EDC1. En parallèle, l'adresse AddL1 est convertie en deux adresses physiques Add1A et Add1B par le circuit 107. La donnée Data1 et le code EDC1 sont ensuite utilisés, par le circuit 103, pour fournir le mot binaire Code1. Le mot binaire Code1 est alors divisé en deux parties, les deux mots binaires Code1A et Code1B, par le circuit 104. Les mots binaires Code1A et Code1B sont stockés, respectivement, dans le circuit mémoire 105 et dans le circuit mémoire 106 aux adresses Add1A et Add1B. Ainsi, la donnée Data1 est stockée dans les circuits mémoire 105 et 106, sous la forme des mots binaires Code1A et Code1B.

La figure 2 représente, schématiquement et sous forme de blocs, une autre partie 11 de l'architecture du mode de réalisation du système électronique 1, dont la partie 10 est décrite en relation avec la figure 1. La partie 11 est adaptée à la lecture de données dans des mémoires du système électronique 1. Plus particulièrement, la partie 11 est, en figure 2, adaptée à la lecture de la donnée Data1 écrite en mémoire à l'adresse AddL1 comme décrit en relation avec la figure 1.

La partie 11 comprend :
- un processeur 111 (CPU) ;
- un circuit 112 (EDC CHECK) de vérification d'un code correcteur ou détecteur d'erreur ;
- un circuit 113 (EDC REMOVAL) de récupération d'une donnée ;
- un circuit 114 (MERGE) de concaténation de mots binaires ;
- les deux circuits mémoire 105 (MEM1) et 106 (MEM2) identiques ; et
- le circuit 107 (ADD DEC) décodeur d'adresses.

Le processeur 111 est un processeur adapté à demander la lecture de données dans les mémoires 105 et 106. Le processeur 111 fournit, en sortie, une adresse, par exemple l'adresse logique AddL1 décrite en relation avec la figure 1, et reçoit, en entrée, une donnée correspondant à l'adresse, c'est-à-dire la donnée Data1 décrite en relation avec la figure 1. Le processeur 111 est, par exemple, le même processeur que le processeur 101 décrit en relation avec la figure 1, mais, à titre de variante, le processeur 111 peut être un processeur distinct du processeur 101 décrit en relation avec la figure 1.

Le circuit 112 de vérification d'un code correcteur ou détecteur d'erreur est un circuit adapté à vérifier le code EDC1 associé à la donnée Data1. Le circuit 112 reçoit, en entrée, le mot binaire Code1 et l'adresse logique AddL1, et fournit, en sortie, un signal d'erreur ErrEDC1. Pour vérifier le code EDC1, le circuit 112 retrouve, à partir du mot binaire Code1, la donnée Data1 et le code EDC1. Ensuite, le circuit 112 calcule un nouveau code détecteur ou correcteur d'erreur à partir de la donnée Data1 et de l'adresse AddL1 fournie par le processeur 111. Le nouveau code est alors comparé au code EDC1. S'ils sont égaux, alors il n'y a pas d'erreur. S'ils ne le sont pas, alors il y a une erreur. L'erreur éventuelle est indiquée par l'intermédiaire du signal ErrEDC1. Le circuit 102 décrit en relation avec la figure 1 fait, par exemple, partie du circuit 112, mais, à titre de variante, les circuits 102 et 112 peuvent être des circuits distincts.

Le circuit 113 de récupération d'une donnée est un circuit adapté à récupérer la donnée Data1 à partir du mot binaire Code1. Le circuit 113 reçoit, en entrée, le mot binaire Code1, et fournit, en sortie, la donnée Data1. A titre d'exemple, quand le mot binaire Code1 est une concaténation de la donnée Data1 et du code EDC1, le circuit 113 est adapté à tronquer le code EDC1 du mot binaire Code1, et, ainsi, ne conserver que la donnée Data1. Le circuit 113 et le circuit 103 décrit en relation avec la figure 1 peuvent, par exemple, faire partie d'un même circuit, ou peuvent, à titre de variante, être deux circuits distincts.

Le circuit 114 de concaténation de mots binaires est un circuit adapté à retrouver le mot binaire Code1 à partir des deux mots binaires Code1A et Code1B. Ainsi, le circuit 114 reçoit, en entrée, les mots binaires Code1A et Code1B, et fournit, en sortie, le mot binaire Code1. Le circuit 114 est particulièrement adapté à concaténer les mots binaires Code1A et Code1B dans l'ordre correct pour retrouver le mot binaire Code1 initial. Le circuit 114 et le circuit 104 décrit en relation avec la figure 1 peuvent, par exemple, faire partie d'un même circuit, ou peuvent, à titre de variante, être deux circuits distincts.

A titre de variante, les parties 10 et 11 pourraient comprendre plus de deux circuits mémoire. Dans ce cas, le circuit 114 est adapté à recevoir, en entrée, autant de mots binaires que de circuits mémoire compris dans les parties 10 et 11. Autrement dit, le circuit 114 est adapté à reformer le mot binaire Code1 à partir d'autant de mots binaires que de circuits mémoire compris dans les parties 10 et 11. De plus, le circuit 107 est, dans ce cas, adapté à fournir autant d'adresses physiques que nécessaire.

Un procédé de lecture de la donnée Data1 mettant en oeuvre la partie 11 du système 1 est le suivant. Le processeur 111 fournit au circuit 107 l'adresse AddL1 à laquelle il veut lire une donnée, en l'occurrence la donnée Data1. Le circuit 107 fournit aux mémoires 105 et 106 les adresses physiques Add1A et Add1B issues de l'adresse logique AddL1. A l'adresse Add1A du circuit mémoire 105 est stocké le mot binaire Code1A, et à l'adresse Add1B du circuit mémoire 106 est stocké le mot binaire Code1B. Les circuits mémoire 105 et 106 fournissent au circuit 114 les deux mots binaires Code1A et Code1B pour reformer le mot binaire Code1. Le circuit 113 se charge d'extraire la donnée Data1 à partir du mot binaire Code1 et de la transmettre au processeur 111. Le circuit 112, quant à lui, vérifie s'il n'y a pas d'erreur, en vérifiant le code EDC1.

Un avantage de ce mode de réalisation est que, lors du procédé de lecture, le circuit 112 permet de détecter une erreur d'adressage de la donnée Data1. En effet, le code EDC1 étant représentatif de la donnée Data1 et de l'adresse logique AddL1 à laquelle la donnée a été écrite, la comparaison du code EDC1 à un code généré à partir de l'adresse logique AddL1 fournie par le processeur 111 peut permettre de détecter une différence d'adresses logiques.

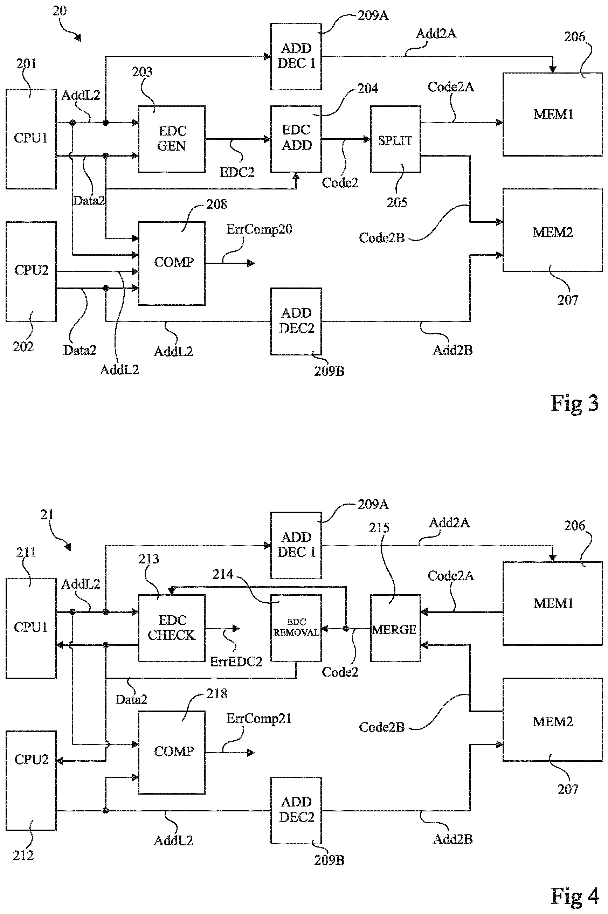

La figure 3 représente, schématiquement et sous forme de blocs, une partie 20 d'une architecture d'un mode de réalisation d'un système électronique 2. La partie 20 est adaptée à l'écriture de données en mémoire du système électronique 2.

La partie 20 comprend :
- deux processeurs 201 (CPU1) et 202 (CPU2) ;
- un circuit 203 (EDC Gen) de génération d'un code correcteur ou détecteur d'erreur ;
- un circuit 204 (EDC ADD) de formation d'un mot binaire ;
- un circuit 205 (SPLIT) de division d'un mot binaire ;
- deux circuits mémoire 206 (MEM1) et 207 (MEM2) ;
- deux circuits 209A (ADD DEC 1) et 209B (ADD DEC 2) décodeur d'adresses ; et
- un circuit 208 (COMP) de comparaison.

Les processeurs 201 et 202 sont des processeurs identiques en structure et adaptés à fournir les mêmes données et commandes. Les processeurs 201 et 202 sont, plus particulièrement, des processeurs adaptés à demander l'écriture de données dans les mémoires 206 et 207. Chaque processeur 201, 202 fournit, en sortie, une donnée Data2 et une adresse logique AddL2. L'adresse AddL2 est l'adresse logique à laquelle la donnée Data2 doit être écrite. L'utilisation des deux processeurs 201 et 202 en parallèle permet, entre autres, la détection d'erreurs par des contrôles par redondance.

Le circuit 203 de génération d'un code correcteur ou détecteur d'erreur est un circuit identique au circuit 102 décrit en relation avec la figure 1. Le circuit 203 reçoit, en entrée, la donnée Data2 provenant du processeur 201, et l'adresse logique AddL2 provenant du processeur 201. Le circuit 203 fournit, en sortie, un code correcteur ou détecteur d'erreur EDC2.

Le circuit 204 de formation d'un mot binaire est un circuit identique au circuit 103 décrit en relation avec la figure 1. Le circuit 204 reçoit, en entrée, le code EDC2 et la donnée Data2 provenant du processeur 201, et fournit, en sortie, un mot binaire Code2.

Le circuit 205 de division d'un mot binaire est un circuit identique au circuit 104 décrit en relation avec la figure 1. Le circuit 205 reçoit, en entrée, le mot binaire Code2, et fournit, en sortie, deux mots binaires Code2A et Code2B correspondant à deux parties du mot binaire Code2.

Les circuits 209A et 209B sont des circuits similaires au circuit 107 décrit en relation avec la figure 1. Le circuit 209A reçoit, en entrée, l'adresse logique AddL2 provenant du processeur 201, et fournit, en sortie, une adresse physique Add2A. Le circuit 209B reçoit, en entrée, l'adresse logique AddL2 provenant du processeur 202, et fournit, en sortie, une adresse physique Add2B.

Les circuits mémoire 206 et 207 sont adaptés à stocker les mots binaires Code2A et Code2B respectivement aux adresses Add2A et Add2B. Les circuits mémoire 206 et 207 sont des circuits mémoire adaptés à stocker le même nombre de mots binaires. Le circuit mémoire 206 reçoit, en entrée, le mot binaire Code2A, et l'adresse Add2A provenant du circuit 209A. Le circuit mémoire 207 reçoit, en entrée, le mot binaire Code2B, et l'adresse Add2B provenant du circuit 209B. Les circuits mémoire 206 et 207 sont, par exemple, des mémoires volatiles. A titre d'exemple, les circuits mémoire 206 et 207 sont de même taille.

A titre de variante, la partie 20 pourrait comprendre plus de deux circuits mémoire identiques en structure et en taille. Dans ce cas, le circuit 205 est adapté à fournir autant de mots binaires de même taille que de circuits mémoire compris dans la partie 20. Autrement dit, le circuit 205 est adapté à diviser le mot binaire Code2 en autant de mots binaires que de circuits mémoire compris dans la partie 20. De plus, les circuits 209A et 209B sont adaptés, dans ce cas, à fournir autant d'adresses physiques à partir de l'adresse logique AddL2 que de circuits mémoire compris dans la partie 20.

Le circuit 208 de comparaison est un circuit adapté à comparer les données Data2 fournies par les processeurs 201 et 202, et les adresses logiques AddL2 fournies par les processeurs 201 et 202. Si les données Data2 transmises par les deux processeurs 201 et 202, ou les adresses AddL2 transmises par les deux processeurs 201 et 202, ne sont pas les mêmes alors une erreur est détectée. Le circuit 208 reçoit, en entrée, les données Data2 transmises par les deux processeurs 201 et 202, et les adresses AddL2 transmises par les deux processeurs 201 et 202, et fournit, en sortie, un signal d'erreur ErrComp20. L'éventuelle erreur détectée par le circuit 208 est transmise via le signal d'erreur ErrComp20.

Un procédé d'écriture en mémoire de la donnée Data2 mettant en oeuvre la partie 20 du système 2 est le suivant. Quand les processeurs 201 et 202 veulent stocker la donnée Data2 en mémoire, ils génèrent l'adresse logique AddL2 à laquelle ils souhaitent la stocker. Le processeur 201 fournit alors la donnée Data2 et l'adresse logique AddL2 au circuit 203 pour que celui-ci génère le code EDC2. En parallèle, l'adresse logique AddL2 est convertie en deux adresses physiques Add2A et Add2B respectivement par les circuits 209A et 209B. Le code EDC2 est donc représentatif de la donnée Data2 et de l'adresse AddL2 fournies par le processeur 201. La donnée Data2 et le code EDC2 sont ensuite utilisés par le circuit 204 pour fournir le mot binaire Code2. Le mot binaire Code2 est ensuite divisé en les deux mots binaires Code2A et Code2B, par le circuit 205. Les mots binaires Code2A et Code2B sont stockés, respectivement, à l'adresse Add2A dans le circuit mémoire 206 et à l'adresse Add2B dans le circuit mémoire 207.

La figure 4 représente, schématiquement et sous forme de blocs, une autre partie 21 de l'architecture du mode de réalisation du système électronique 2, dont la partie 20 est décrite en relation avec la figure 3. La partie 21 est adaptée à la lecture de données dans des mémoires du système électronique 2. Plus particulièrement, la partie 21 est, en figure 4, adaptée à la lecture de la donnée Data2 écrite en mémoire à l'adresse logique AddL2 comme décrit en relation avec la figure 3.

La partie 21 comprend :
- deux processeurs 211 (CPU1) et 212 (CPU2) ;
- un circuit 213 (EDC CHECK) de vérification d'un code correcteur ou détecteur d'erreur ;
- un circuit 214 (EDC REMOVAL) de récupération d'une donnée ;
- un circuit 215 (MERGE) de concaténation de mots binaires ; et
- les deux circuits mémoire 206 (MEM1) et 207 (MEM2) identiques ;
- les deux circuits décodeurs d'adresses 209A (ADD DEC 1) et 209B (ADD DEC 2) ; et
- un circuit comparateur 218 (COMP).

Les processeurs 211 et 212 sont des processeurs identiques au processeur 111. Les processeurs 211 et 212 fournissent, en sortie, chacun l'adresse logique AddL2 à laquelle ils souhaitent lire une donnée, et reçoivent chacun en retour la donnée Data2. Les processeurs 211 et 212 sont, par exemple, les mêmes processeurs que les processeurs 201 et 202 décrits en relation avec la figure 3, mais, à titre de variante, les processeurs 211 et 212 peuvent être des processeurs distincts des processeurs 201 et 202.

Le circuit 213 de vérification d'un code correcteur ou détecteur d'erreur est un circuit identique au circuit 112 décrit en relation avec la figure 2. Le circuit 213 reçoit, en entrée, l'adresse logique AddL2 transmise par le processeur 211 et le mot binaire Code2, et fournit, en sortie, un signal d'erreur ErrEDC2. Le circuit 213 et le circuit 203, décrit en relation avec la figure 3, peuvent, par exemple, faire partie d'un même circuit, ou peuvent, à titre de variante, être deux circuits distincts.

Le circuit 214 de récupération d'une donnée est un circuit identique au circuit 113 décrit en relation avec la figure 2. Le circuit 214 reçoit, en entrée, le mot binaire Code2, et fournit, en sortie, la donnée Data2.

Le circuit 215 de concaténation de mots binaires est un circuit identique au circuit 114 décrit en relation avec la figure 2. Le circuit 215 reçoit, en entrée, les deux mots binaires Code2A et Code2B, et fournit, en sortie, le mot binaire Code2. Le circuit 215 et le circuit 205, décrit en relation avec la figure 3, peuvent, par exemple, faire partie d'un même circuit, ou, à titre de variante, peuvent être des circuits distincts.

Les circuits 209A et 209B convertissent l'adresse logique AddL2 en, respectivement, les adresses physiques Add2A et Add2B. Le circuit 209A reçoit, en entrée, l'adresse logique AddL2 provenant du processeur 211, et fournit, en sortie, l'adresse physique Add2A. Le circuit 209B reçoit, en entrée, l'adresse logique AddL2 provenant du processeur 212, et fournit, en sortie, l'adresse physique Add2B.

Les circuits mémoire 206 et 207 stockent les mots binaires Code2A et Code2B, respectivement, aux adresses Add2A et Add2B. Le circuit mémoire 206 reçoit l'adresse Add2A de la part circuit 209A, et le circuit mémoire 207 reçoit l'adresse Add2B de la part du circuit 209B.

A titre de variante, les parties 20 et 21 pourraient comprendre plus de deux circuits mémoire. Dans ce cas, le circuit 215 est adapté à recevoir, en entrée, autant de mots binaires que de circuits mémoire compris dans les parties 20 et 21. Autrement dit, le circuit 215 est adapté à reformer le mot binaire Code2 à partir d'autant de mots binaires que de circuits mémoire compris dans les parties 20 et 21. De plus, les circuits 209A et 209B sont adaptés à fournir autant d'adresses physiques à partir de l'adresse logique AddL2 que de circuits mémoire présents dans les parties 20 et 21.

Le circuit comparateur 218 est un circuit adapté à comparer les adresses logiques AddL2 transmises par les processeurs 211 et 212. Le circuit comparateur 218 reçoit, en entrée, l'adresse AddL2 fournie par le processeur 211 et l'adresse AddL2 fournie par le processeur 212, et fournit, en sortie, un signal d'erreur ErrComp21. Si les adresses logiques transmises par les processeurs 211 et 212 ne sont pas identiques alors une erreur est détectée, et est transmise par l'intermédiaire du signal d'erreur ErrComp21. Le circuit 218 et le circuit 208 décrit en relation avec la figure 3 peuvent, par exemple, faire partie d'un même circuit, mais, à titre de variante, les circuits 208 et 218 peuvent être des circuits distincts.

Un procédé de lecture de la donnée Data2 mettant en oeuvre la partie 21 du système 2 est le suivant. Les processeurs 211 et 212 fournissent aux circuits 209A et 209B l'adresse AddL2 à laquelle ils veulent lire une donnée, en l'occurrence la donnée Data2. Les circuits 209A et 209B fournissent les adresses physiques Add2A et Add2B aux circuits mémoire 206 et 207. Le circuit 218 de comparaison vérifie si les processeurs 211 et 212 transmettent la même adresse logique AddL2. A l'adresse Add2A du circuit mémoire 206 est stocké le mot binaire Code2A, et à l'adresse Add2B du circuit mémoire 207 est stocké le mot binaire Code2B. Les circuits mémoire 206 et 207 fournissent au circuit 215 les deux mots binaires Code2A et Code2B pour reformer le mot binaire Code2. Le circuit 214 s'occupe de retrouver la donnée Data2 et de la transmettre aux processeurs 211 et 212. Le circuit 213, quant à lui, vérifie s'il n'y a pas d'erreur.

Un avantage de ce mode de réalisation est que, lors du procédé de lecture, le circuit 213 permet de détecter une erreur d'adressage de la donnée Data2. En effet, le code EDC2 étant représentatif de la donnée Data2 et de l'adresse logique à laquelle la donnée a été écrite, la comparaison du code EDC2 à un code généré à partir de l'adresse logique AddL2 fournie par le processeur 211 peut permettre de détecter une différence d'adresses logiques.

Un autre avantage de ce mode de réalisation est que l'utilisation de deux processeurs 201 et 202, et 211 et 212, en parallèle permet de détecter les erreurs émises lors de la commande de lecture ou de la commande d'écriture. Ces erreurs sont détectées par les circuits 208 et 218.

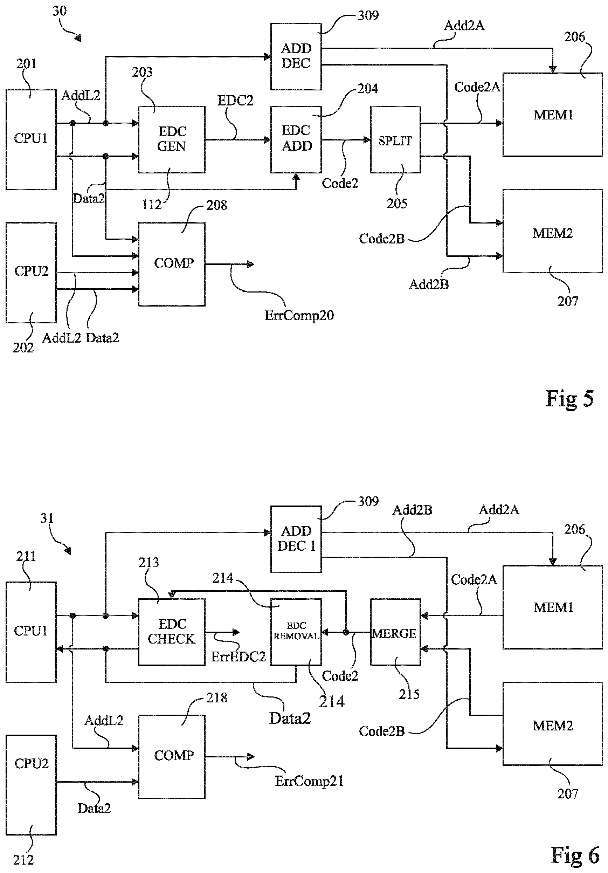

La figure 5 représente, schématiquement et sous forme de blocs, une partie 30 d'une architecture d'un mode de réalisation d'un système électronique 3. La partie 30 est adaptée à l'écriture de données en mémoire du système électronique 3.

Le système électronique 3 est similaire au système électronique 2 dont les parties 20 et 21 sont décrites en relation avec les figures 3 et 4. Les éléments communs aux systèmes 2 et 3 ne seront pas décrits à nouveau ci-après.

La partie 30 comprend sensiblement les mêmes circuits que la partie 20 du système 2. Ainsi, la partie 30 comprend :
- deux processeurs 201 (CPU1) et 202 (CPU2) ;
- un circuit 203 (EDC Gen) de génération d'un code correcteur ou détecteur d'erreur ;
- un circuit 204 (EDC ADD) de formation d'un mot binaire ;
- un circuit 205 (SPLIT) de division d'un mot binaire ;
- deux circuits mémoire 206 (MEM1) et 207 (MEM2) identiques ;
- un circuit décodeur d'adresses 309 (ADD DEC) ; et
- un circuit 208 (COMP) de comparaison.

La différence entre la partie 20 du système 2 et la partie 30 du système 3 est que, dans la partie 30, l'adresse logique AddL2 est transmise par le processeur 201 au circuit 309 qui est identique au circuit 107 décrit en relation avec la figure 1. Le circuit 309 fournit en sortie les deux adresses physiques Add2A et Add2B. Les deux circuits mémoire 206 et 207 reçoivent, respectivement, les adresses physiques Add2A et Add2B de la part du circuit 309. Dans la partie 20, chaque circuit mémoire reçoit l'adresse physique Add2A ou Add2B de la part d'un circuit décodeur différent. Dans ce mode de réalisation, le processeur 202 ne fournit l'adresse logique AddL2 qu'au circuit comparateur 208.

La figure 6 représente, schématiquement et sous forme de blocs, une autre partie 31 de l'architecture du mode de réalisation du système électronique 3, dont la partie 30 est décrite en relation avec la figure 5. Le système électronique 3 est un mode de réalisation préféré. La partie 31 est adaptée à la lecture de données dans des mémoires du système électronique 3. Plus particulièrement, la partie 31 est, en figure 6, adaptée à la lecture de la donnée Data2 écrite en mémoire à l'adresse AddL2 comme décrit en relation avec la figure 3.

Le système électronique 3 est similaire au système électronique 2 dont les parties 20 et 21 sont décrits en relation avec les figures 3 et 4. Les éléments communs aux systèmes 2 et 3 ne seront pas décrits de nouveau ci-après.

La partie 31 comprend certains des circuits de la partie 21 du système 2. Ainsi, la partie 31 comprend :
- deux processeurs 211 (CPU1) et 212 (CPU2) ;
- le circuit 213 (EDC CHECK) de vérification d'un code correcteur ou détecteur d'erreur ;
- le circuit 214 (EDC REMOVAL) de récupération d'une donnée ;
- le circuit 215 (MERGE) de concaténation de mots binaires ; et
- les deux circuits mémoire 206 (MEM1) et 207 (MEM2) identiques ;
- le circuit décodeur d'adresses 309 (ADD DEC) ; et
- le circuit comparateur 218(COMP).

La différence entre la partie 21 du système 2 et la partie 31 du système 3 est que, dans la partie 31, les deux circuits mémoire 206 et 207 reçoivent les adresses Add2A et Add2B de la part du circuit 309. Dans la partie 20, chaque circuit mémoire reçoit l'adresse Add2A, Add2B de la part d'un circuit décodeur d'adresses différent. Dans ce mode de réalisation, le processeur 212 ne fournit l'adresse logique AddL2 qu'au circuit comparateur 218.

Un avantage de ce mode de réalisation est que, lors du procédé de lecture, le circuit 213 permet de détecter une erreur d'adressage de la donnée Data2. En effet, le code EDC2 étant représentatif de la donnée Data2 et de l'adresse logique à laquelle la donnée a été écrite, la comparaison du code EDC2 à un code généré à partir de l'adresse logique AddL2 fournie par le processeur 211 permet de détecter une différence d'adresses logiques.

Un autre avantage de ce mode de réalisation est que les deux mots binaires Code2A et Code2B sont écrits à des adresses physiques Add2A et Add2B, issues de la même adresse logique AddL2, dans les circuits mémoire 206 et 207, même si les adresses logiques AddL2 transmises par les processeurs 201 et 202 sont différentes par erreur.

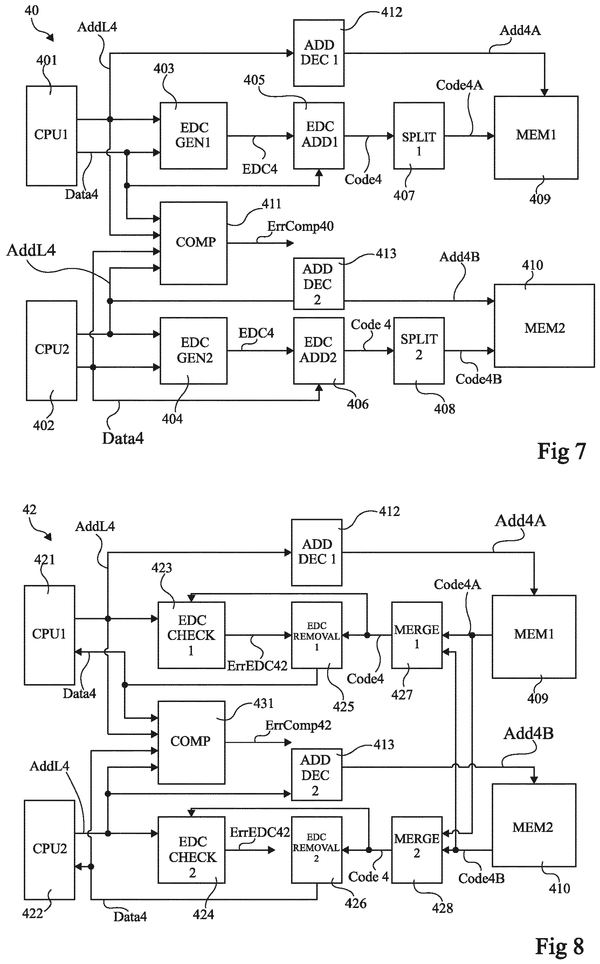

La figure 7 représente, schématiquement et sous forme de blocs, une partie 40 d'une architecture d'un mode de réalisation d'un système électronique 4. La partie 40 est adaptée à l'écriture de données en mémoire du système électronique 4.

La partie 40 comprend :
- deux processeurs 401 (CPU1) et 402 (CPU2) ;
- deux circuits 403 (EDC GEN 1) et 404 (EDC GEN 2) de génération d'un code correcteur ou détecteur d'erreur ;
- deux circuits 405 (EDC ADD 1) et 406 (EDC ADD 2) de formation d'un mot binaire ;
- des circuits 407 (SPLIT 1) et 408 (SPLIT 2) de division d'un mot binaire ;
- deux circuits mémoire 409 (MEM1) et 410 (MEM2) identiques ;
- deux circuits décodeurs d'adresses 412 (ADD DEC 1) et 413 (ADD DEC2) ; et
- un circuit 411 (COMP) de comparaison.

Les processeurs 401 et 402 sont similaires aux processeurs 201 et 202 de la partie 20 du système 2 décrits en relation avec la figure 3. Les processeurs 401 et 402 sont identiques en structure et sont adaptés à fournir les mêmes données et commandes. Les processeurs 401 et 402 sont, plus particulièrement, des processeurs adaptés à demander l'écriture de données dans les mémoires 409 et 410. Chaque processeur 401, 402 fournit, en sortie, une donnée Data4 à écrire en mémoire et une adresse logique AddL4. L'adresse AddL4 est l'adresse logique à laquelle la donnée Data4 doit être écrite en mémoire. L'utilisation des deux processeurs 401 et 402 en parallèle, permet, entre autres, la détection d'erreurs par des contrôles par redondance.

Les circuits 403 et 404 de génération d'un code correcteur ou détecteur d'erreur sont des circuits identiques aux circuits 102 décrit en relation avec la figure 1. Le circuit 403 reçoit, en entrée, la donnée Data4 et l'adresse logique AddL4 provenant toutes deux du processeur 401, et fournit, en sortie, un code EDC4. Le circuit 404 reçoit, en entrée, la donnée Data4 et l'adresse logique AddL4 provenant toutes deux du processeur 402, et fournit, en sortie, un code correcteur ou détecteur d'erreur EDC4.

Les circuits 405 et 406 de formation d'un mot binaire sont des circuits identiques au circuit 103 décrit en relation avec la figure 1. Le circuit 405 reçoit, en entrée, le code EDC4 provenant du circuit 403, et fournit, en sortie, le mot binaire Code4. Le circuit 406 reçoit, en entrée, le code EDC4 provenant du circuit 404, et fournit, en sortie, le mot binaire Code4.

Les circuits 407 et 408 de division d'un mot binaire sont des circuits adaptés à diviser le mot binaire Code4 en plusieurs mots binaires. Le circuit 407 reçoit, en entrée, le mot binaire Code4 provenant du circuit 405, et fournit, en sortie, dans cet exemple, une des parties du mot binaire Code4, le mot binaire Code2A. Le circuit 408 reçoit, en entrée, le mot binaire Code4 provenant du circuit 406, et fournit, en sortie, dans cet exemple, une des parties du mot binaire Code4, le mot binaire Code2B.

Les circuits décodeurs d'adresses 412 et 413 sont des circuits identiques au circuit 107 décrit en relation avec la figure 1. Les circuits 412 et 413 convertissent l'adresse logique AddL4 en, respectivement, les adresses physiques Add4A et Add4B. Le circuit 412 reçoit, en entrée, l'adresse logique AddL4 provenant du processeur 401, et fournit, en sortie, l'adresse physique Add4A. Le circuit 413 reçoit, en entrée, l'adresse logique AddL4 provenant du processeur 402, et fournit, en sortie, l'adresse physique Add4B.

Les circuits mémoire 409 et 410 sont des circuits mémoire identiques aux circuits mémoire 105 et 106 décrits en relation avec la figure 1. Le circuit mémoire 409 reçoit, en entrée, le mot binaire Code4A provenant du circuit 407, et l'adresse Add4A provenant du circuit 412. Le circuit mémoire 410 reçoit, en entrée, le mot binaire Code4B provenant du circuit 408, et l'adresse Add4B provenant du circuit 413. A titre d'exemple, les circuits mémoire 409 et 410 sont de même taille.

A titre de variante, la partie 40 pourrait comprendre plus de deux circuits mémoire. Dans ce cas, la partie 40 comprend autant de circuits de génération d'un code correcteur ou détecteur d'erreur, autant de circuits de formation d'un mot binaire, et autant de circuits de division d'un mot binaire que de circuits mémoire dans la partie 40. De plus, les circuits de division de mots binaires sont adaptés à diviser le mot binaire qu'ils reçoivent en entrée en autant de mots binaires que le nombre de circuits mémoire compris dans la partie 40. Les circuits 412 et 413 décodeur d'adresses sont adaptés à fournir autant d'adresses physiques que de circuits mémoire compris dans la partie 40.

Le circuit 411 de comparaison est un circuit identique au circuit 208 décrit en relation avec la figure 3. Le circuit 411 reçoit, en entrée, les données Data4 transmises par les processeurs 401 et 402, et les adresses AddL4 transmises par les processeurs 401 et 402. Le circuit 411 fournit, en sortie, un signal d'erreur ErrComp40.

Un procédé d'écriture en mémoire de la donnée Data4 mettant en oeuvre la partie 40 du système 4 est le suivant. Quand les processeurs 401 et 402 veulent stocker la donnée Data4 en mémoire, ils génèrent l'adresse logique AddL4 à laquelle ils souhaitent la stocker. Le processeur 401, respectivement 402, fournit alors la donnée Data4 et l'adresse AddL4 au circuit 403, respectivement 404, pour que celui génère le code EDC4. En parallèle, le processeur 401, respectivement 402, fournit l'adresse AddL4 au circuit 412, respectivement 413, pour obtenir l'adresse physique Add4A, respectivement Add4B. Le code EDC4 est donc représentatif de la donnée Data4 et de l'adresse logique AddL4 fournies par les processeurs 401 et 402. Le circuit 405 génère ensuite le mot binaire Code4 à partir du code EDC4 fourni par le circuit 403 et à partir de la donnée Data4 fournie par le processeur 401. Le circuit 406 génère ensuite le mot binaire Code4 à partir du code EDC4 fourni par le circuit 404 et à partir de la donnée Data4 fournie par le processeur 402. Les circuits 407 et 408 divisent les mots binaires Code4, reçus respectivement des circuits 405 et 406, en les mots binaires Code4A et Code4B. Le mot binaire Code4A est stocké dans la mémoire 409 à l'adresse Add4A transmise par le circuit 412, et le mot binaire Code4B est stocké dans la mémoire 410 à l'adresse Add4B transmise par le circuit 413.

La figure 8 représente, schématiquement et sous forme de blocs, une autre partie 42 de l'architecture du mode de réalisation du système électronique 4, dont la partie 40 est décrite en relation avec la figure 7. La partie 42 est adaptée à la lecture de données dans des mémoires du système électronique 4. Plus particulièrement, la partie 42 est, en figure 8, adaptée à la lecture de la donnée Data4 écrite à l'adresse logique AddL4 dans les circuits mémoire 409 et 410 comme décrit en relation avec la figure 7.

La partie 42 comprend :
- deux processeurs 421 (CPU1) et 422 (CPU2) ;
- des circuits 423 (EDC CHECK 1) et 424 (EDC CHECK 2) de vérification d'un code correcteur ou détecteur d'erreur ;
- des circuits 425 (EDC REMOVAL 1) et 426 (EDC REMOVAL 2) de récupération d'une donnée ;
- des circuits 427 (MERGE 1) et 428 (MERGE 2) de concaténation de mots binaires ; et
- les deux circuits mémoire 409 (MEM1) et 410 (MEM2) ;
- les deux circuits décodeurs d'adresses 412 (ADD DEC 1) et 413 (ADD DEC 2) ; et
- un circuit comparateur 431 (COMP).

Les deux processeurs 421 et 422 sont des processeurs identiques aux processeurs 211 et 212 décrit en relation avec la figure 4. Les processeurs 421 et 422 fournissent, en sortie, chacun l'adresse logique AddL4 à laquelle ils souhaitent lire une donnée, et reçoivent chacun en retour la donnée Data4. Les processeurs 421 et 422 sont, par exemple, les mêmes processeurs que les processeurs 401 et 402, mais, à titre de variante, les processeurs 421 et 422 peuvent être des processeurs distincts des processeurs 401 et 402.

Les circuits 423 et 424 de vérification d'un code correcteur ou détecteur d'erreur sont des circuits identiques au circuit 112 décrits en relation avec la figure 2. Le circuit 423 reçoit en entrée l'adresse logique AddL4 provenant du processeur 421 et le mot binaire Code4 provenant du circuit 427, et fournit, en sortie, un signal d'erreur ErrEDC42. Le circuit 424 reçoit en entrée l'adresse AddL4 provenant du processeur 422 et le mot binaire Code4 provenant du circuit 428, et fournit, en sortie, un signal d'erreur ErrEDC42. Les circuits 403 et 423 peuvent, par exemple, faire partie d'un même circuit, mais peuvent, à titre de variante, être des circuits distincts. Les circuits 404 et 424 peuvent, par exemple, faire partie d'un même circuit, mais peuvent, à titre de variante, être des circuits distincts.

Les circuits 425 et 426 de récupération d'une donnée sont des circuits identiques au circuit 113 décrit en relation avec la figure 2. Le circuit 425 reçoit, en entrée, le mot binaire Code4 provenant du circuit 427, et fournit, en sortie, la donnée Data4. Le circuit 426 reçoit, en entrée, le mot binaire Code4 provenant du circuit 428, et fournit, en sortie, la donnée Data4. Les circuits 405 et 425 peuvent, par exemple, faire partie d'un même circuit, mais peuvent, à titre de variante, être des circuits distincts. Les circuits 406 et 426 peuvent, par exemple, faire partie d'un même circuit, mais peuvent, à titre de variante, être des circuits distincts.

Les circuits 427 et 428 de concaténation de mots binaires sont des circuits identiques au circuit 114 décrit en relation avec la figure 2. Le circuit 427 reçoit, en entrée, les mots binaires Code4A et Code4B, et fournit, en sortie, le mot binaire Code4. Le circuit 428 reçoit, en entrée, les mots binaires Code4A et Code4B, et fournit, en sortie, le mot binaire Code4. Les circuits 407 et 427 peuvent par exemple, faire partie d'un même circuit, mais peuvent, à titre de variante, être des circuits distincts. Les circuits 408 et 428 peuvent, par exemple, faire partie d'un même circuit, mais peuvent, à titre de variante, être des circuits distincts.

Les circuits 412 et 413 convertissent l'adresse AddL4 en, respectivement, les adresses physiques Add4A et Add4B. Le circuit 412 reçoit, en entrée, l'adresse logique AddL4, et fournit, en sortie, l'adresse physique Add4A. Le circuit 413 reçoit, en entrée, l'adresse logique AddL4, et fournit, en sortie, l'adresse physique Add4B.

Les circuits mémoire 409 et 410 stockent les mots binaires Code4A et Code4B, respectivement, aux adresses Add4A et Add4B. Le circuit mémoire 409 reçoit l'adresse Add4A de la part du circuit 412, et le circuit mémoire 410 reçoit l'adresse Add4B de la part du circuit 413.

A titre de variante, les parties 40 et 42 pourraient comprendre plus de deux circuits mémoire. Dans ce cas, la partie 42 comprend autant de circuits de vérification de code correcteur ou détecteur d'erreur, autant de circuits de récupération d'une donnée, et autant de circuits de concaténation de mots binaires que de circuits mémoire dans la partie 41. De plus, les circuits de division de mots binaires sont, dans ce cas, adaptés à diviser le mot binaire qu'ils reçoivent en autant de mots binaires que le nombre de circuits mémoire compris dans la partie 41. Des plus, les circuits 412 et 413 sont adaptés à fournir autant d'adresses physiques issues de l'adresse logique AddL4 que de circuits mémoire compris dans la partie 42.

Le circuit comparateur 431 est un circuit adapté à comparer, entre elles, les adresses AddL4 transmises par les processeurs 421 et 422, et les données Data4 transmises par les circuits 425 et 426. Le circuit comparateur 431 reçoit, en entrée, l'adresse AddL4 fournie par le processeur 421 et l'adresse AddL4 fournie par le processeur 422, et la donnée Data4 transmise par le circuit 425, et la donnée Data4 transmise par le circuit 426. Le circuit comparateur 431 fournit, en sortie, un signal d'erreur Errcomp42. Si les adresses transmises par les processeurs 421 et 422 ne sont pas identiques alors une erreur est détectée, et est transmise par l'intermédiaire du signal d'erreur ErrComp42. Le circuit 431 et le circuit 411 décrit en relation avec la figure 7 peuvent, par exemple, faire partie d'un même circuit, mais, à titre de variante, les circuits 411 et 431 peuvent être des circuits distincts.

Un procédé de lecture de la donnée Data4 mettant en oeuvre la partie 42 du système 4 est le suivant. Les processeurs 421 et 422 fournissent aux circuits 412 et 413 l'adresse AddL4 à laquelle ils veulent lire une donnée, en l'occurrence la donnée Data4. Les circuits 412 et 413 fournissent les adresses physiques Add4A et Add4B aux circuits mémoire 409 et 410. Le circuit 431 de comparaison vérifie si les processeurs 421 et 422 transmettent la même adresse AddL4. A l'adresse Add4A du circuit mémoire 409 est stocké le mot binaire Code4A, et à l'adresse Add4B du circuit mémoire 410 est stocké le mot binaire Code4B. Les circuits mémoire 409 et 410 fournissent aux circuits 427 et 428 les deux mots binaires Code4A et Code4B pour reformer le mot binaire Code4. Le circuit 425 s'occupe de retrouver la donnée Data4 à partir du mot binaire Code4 transmis par le circuit 427, le circuit 426 s'occupe de retrouver la donnée Data4 à partir du mot binaire Code4 transmis par le circuit 428. Le processeur 421 reçoit alors la donnée Data4 de la part du circuit 425, et le processeur 422 reçoit la donnée Data4 de la part du circuit 426. Le circuit comparateur 431 vérifie la correspondance entre les données Data4 fournies aux processeurs 421 et 422. Les circuits 423 et 424 vérifient, chacun de leur côté, le code EDC4.

Un avantage de ce mode de réalisation est que, lors du procédé de lecture, les circuits 423 et 424 permettent de détecter une erreur d'adressage de la donnée Data4. En effet, le code EDC4 étant représentatif de la donnée Data4 et de l'adresse logique à laquelle la donnée a été écrite, la comparaison du code EDC4 à un code généré à partir de l'adresse logique AddL4 fournie par les processeurs 421 et 422 permet de détecter une différence d'adresses.

Un autre avantage de ce mode de réalisation est que l'utilisation de deux processeurs 401 et 402, et 421 et 422, en parallèle permet de détecter les erreurs émises lors de la commande de lecture ou de la commande d'écriture. Ces erreurs sont détectées par les circuits 411 et 431.

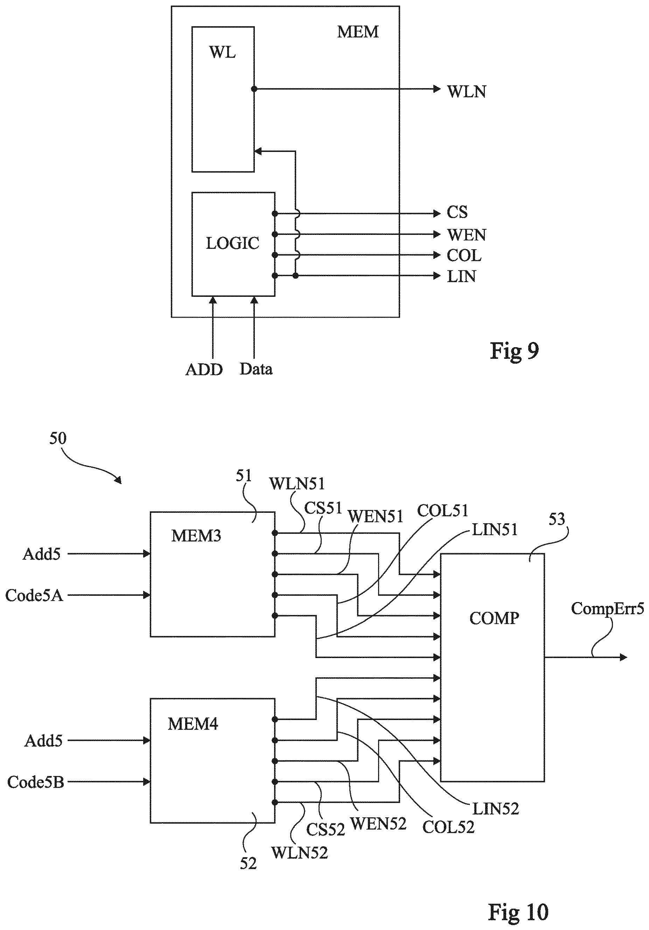

La figure 9 représente, schématiquement et sous forme de blocs, une partie d'un circuit mémoire MEM. Le circuit mémoire MEM est, par exemple, le type de circuit mémoire utilisé par les systèmes 1 à 4 décrits en relation avec les figures 1 à 8.

La partie du circuit mémoire MEM comprend un circuit de commande LOGIC et un circuit de commande de ligne WL.

Le circuit de commande LOGIC est un circuit adapté à traiter les différentes commandes reçues de la part du système dont le circuit mémoire MEM fait partie. Le circuit LOGIC reçoit, en entrée, une adresse Add et une donnée Data à écrire. Le circuit LOGIC fournit, en sortie, les signaux suivants :
- un signal CS de sélection du circuit mémoire MEM ;
- un signal WEN d'activation d'écriture ;
- un signal COL de sélection/numéro de colonne ; et
- un signal LIN de sélection/numéro de ligne.

L'adresse Add est, de préférence, une adresse physique, c'est-à-dire directement interprétable en coordonnées de ligne et de colonne dans le circuit mémoire. En variante, cette adresse est une adresse logique fournie par le processeur et traduite par un circuit décodeur d'adresses associé au circuit mémoire, c'est-à-dire faisant partie du circuit mémoire.

Le signal CS permet de sélectionner le circuit mémoire MEM lors d'une opération de lecture ou d'écriture.

Le signal WEN permet d'indiquer au circuit mémoire MEM la nature de la commande reçue, et plus particulièrement, si une opération d'écriture est demandée.

Les signaux COL et LIN sont les signaux générés à partir de l'adresse Add reçue par le circuit LOGIC, et sont les signaux permettant de venir sélectionner les points mémoires (non représentés en figure 9) du circuit mémoire dans lesquelles on souhaite écrire la donnée Data.

Le circuit de commande de ligne WL est un circuit adapté à sélectionner la ligne de mots correspondant à l'adresse Add reçue par le circuit mémoire. Le circuit WL reçoit, en entrée, le signal LIN de sélection/numéro de ligne, et fournit, en sortie, des mots WLN. En figure 9, seul un mot WLN est représentée.

La figure 10 représente, schématiquement et sous forme de blocs, une partie 50 d'une architecture d'un système électronique 5. La partie 50 est adaptée à la détection d'erreurs lors de l'écriture de données dans des mémoires.

La partie 50 du système 5 comprend :
- deux circuits mémoire 51 (MEM3) et 52 (MEM4) ; et
- un circuit de comparaison 53 (COMP).

Les circuits mémoire 51 et 52 sont des circuits mémoire identiques en structure et en taille au type de la mémoire MEM décrit en relation avec la figure 9. Ainsi, les circuits mémoire 51 et 52 reçoivent, en entrée, chacun une adresse physique Add5. Le circuit mémoire 51 reçoit, en entrée, en outre, un mot binaire Code5A à stocker à l'adresse Add5. Le circuit mémoire 52 reçoit, en entrée, en outre, un mot binaire Code5B à stocker à l'adresse Add5. Comme décrit en relation avec la figure 9, chaque circuit mémoire 51, respectivement 52, fournit, en sortie, les signaux de sortie suivants :
- un mot WLN51, respectivement WLN52 ;
- un signal CS51, respectivement CS52, de sélection du circuit mémoire 51, respectivement du circuit mémoire 52 ;
- un signal WEN51, respectivement WEN52, d'activation d'écriture ;
- un signal COL51, respectivement COL52, de sélection/numéro de colonne ; et
- un signal LIN51, respectivement LIN52, de sélection/numéro de ligne.

Les mots binaires Code5A et Code5B sont des mots binaires de même taille représentatifs tous les deux d'une donnée à écrire en mémoire. A titre d'exemple, les mots binaires Code5A et Code5B sont obtenus en divisant en deux la donnée à écrire en mémoire. Selon un autre exemple, les mots binaires Code5A et Code5B sont obtenus de la même façon que les mots binaires Code1A et Code1B décrits en relation avec la figure 1.

Le circuit de comparaison 53 est un circuit permettant de comparer les signaux de sortie des deux circuits mémoire 51 et 52 pour détecter une erreur lors d'une opération d'écriture. Le circuit de comparaison 53 reçoit, en entrée, les signaux suivants :
- les mots WLN51 et WLN52 ;
- les signaux CS51 et CS52 ;
- les signaux WEN51 et WEN52 ;
- les signaux COL51 et COL52 ; et
- les signaux LIN51 et LIN52.

Le circuit de comparaison 53 fournit, en sortie, un signal de comparaison CompErr5. Le circuit de comparaison 53 compare, plus particulièrement, chaque signal de sortie du circuit mémoire 51 avec le signal de sortie homologue du circuit mémoire 52. Autrement dit, le circuit de comparaison 53 est adapté à :
- comparer les mots WLN51 et WLN52 ;
- comparer les signaux CS51 et CS52 ;
- comparer les signaux WEN51 et WEN52 ;
- comparer les signaux COL51 et COL52 ; et
- comparer les signaux LIN51 et LIN52.

Le circuit de comparaison 53 peut être un assemblage de portes logiques de type OU EXCLUSIF.

A titre de variante, la partie 50 pourrait comprendre plus de deux circuits mémoire. Dans ce cas, le circuit de comparaison 53 est adapté à recevoir, en entrée, tous les signaux de sortie des circuits mémoire de la partie 50. De plus, chacun de ces circuits mémoire est adapté à stocker un mot binaire représentatif de la donnée à écrire en mémoire différent des mots binaires stockés dans les autres circuits mémoire.

Un procédé de détection d'erreurs de lecture mettant en oeuvre la partie 50 du système 5 est le suivant. Pendant l'écriture des mots binaires Code5A et Code5B dans les circuits mémoire 51 et 52 à l'adresse Add5, les circuits mémoire 51 et 52 transmettent leurs signaux de sortie au circuit de comparaison 53. Les mots binaires Code5A et Code5B étant des mots binaires, de même taille, stockés à une adresse identique dans des circuits mémoire identiques, ainsi, les signaux de sortie des circuits mémoire 51 et 52 devraient donc être identiques. Le circuit de comparaison 53 compare alors les signaux de sortie des circuits mémoire 51 et 52, chaque différence entre deux signaux peut signifier une erreur. Une éventuelle erreur est transmise par l'intermédiaire du signal CompErr5.

Un avantage de ce mode de réalisation est qu'il permet de détecter les erreurs d'adresse pendant une opération d'écriture d'une donnée en mémoire sans nécessiter une opération de lecture de ladite donnée.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art.

En particulier, les modes de réalisation décrits en relation avec les figures 1 et 2, 3 et 4, 5 et 6, et 7 et 8 sont tous compatibles avec le mode de réalisation décrit en relation avec les figures 9 et 10.

De plus, les modes de réalisation décrits en relation avec les figures 3 et 4, 5 et 6, et 7 et 8 comprennent deux processeurs identiques, mais à titre de variante, ces modes de réalisation pourraient comprendre plus de deux processeurs.

Enfin, la mise en oeuvre pratique des modes de réalisation et variantes décrits est à la portée de l'homme du métier à partir des indications fonctionnelles données ci-dessus.

## Revendications

1. Procédé de détection d'une erreur d'écriture d'une donnée (Data5) en mémoire dans lequel :
- au moins deux parties (Code5A, Code5B) de même taille d'un mot binaire (Code5) représentatif de ladite donnée (Data5) sont stockées à la même adresse (AddL5) dans au moins deux circuits mémoire (51, 52) identiques ; et
- des signaux internes de commande des deux circuits mémoire (51, 52) sont comparés.

2. Procédé selon la revendication 1, dans lequel les signaux internes comprennent un signal de mots (WLN51, WLN52).

3. Procédé selon la revendication 1 ou 2, dans lequel les signaux internes comprennent un signal de sélection d'un des circuits mémoire (CS51, CS52).

4. Procédé selon l'une quelconque des revendications 1 à 3, dans lequel les signaux internes comprennent un signal d'activation d'écriture (WEN51, WEN52).

5. Procédé selon l'une quelconque des revendications 1 à 4, dans lequel les signaux internes comprennent un signal de sélection/numéro de colonne (COL51, COL52).

6. Procédé selon l'une quelconque des revendications 1 à 5, dans lequel les signaux internes comprennent un signal de sélection/numéro de ligne (LIN51, LIN52).

7. Procédé selon l'une quelconque des revendications 1 à 6, dans lequel le mot binaire est obtenu à partir de ladite donnée (Data5) et d'un code correcteur ou détecteur d'erreur, ledit code correcteur ou détecteur d'erreur étant représentatif de ladite donnée (Data5) et de ladite adresse (AddL5).

8. Procédé selon la revendication 7, dans lequel le mot binaire est obtenu par concaténation de ladite donnée (Data5) et du code correcteur ou détecteur d'erreur.

9. Procédé selon la revendication 7 ou 8, dans lequel le code correcteur ou détecteur d'erreur est obtenu par un procédé de signature.
